# FASCICULE DE BREVET EUROPEEN

(11) **EP 2 758 560 B1**
(45) Date de publication et mention de la délivrance du brevet: **22.07.2020**
(21) Numéro de dépôt: 12773043.0
(22) Date de dépôt: 14.09.2012
(51) Int. Cl.: C03C 17/00, C23C 14/35, F24S 23/70, C03C 17/36, C23C 14/18, G02B 5/08

(54) **MIROIR A COUCHE ARGENT PAR MAGNETRON**
SPIEGEL MIT EINER MAGNETRON-SPUTTER-SILBERSCHICHT
MIRROR HAVING A MAGNETRON-SPUTTERED SILVER LAYER

(30) Priorité: 19.09.2011 FR 1158308
(43) Date de publication de la demande: 30.07.2014
(73) Titulaire: SAINT-GOBAIN GLASS FRANCE, 92400 Courbevoie (FR)
(72) Inventeur: LEYDER, Charles, 75019 Paris (FR); MOREAU, Virginie, 75018 Paris (FR)
(74) Mandataire: Saint-Gobain Recherche
(86) Numéro de dépôt international: PCT/FR2012/052065
(87) Numéro de publication internationale: WO 2013/041799

(56) Documents cités:
- EP-A1- 1 909 120
- DE-A1-102009 045 582
- US-A- 4 822 120
- US-B1- 6 190 776
- US-B2- 7 871 664

## Description

L'invention concerne le domaine des miroirs dont la couche d'argent constitue la couche réfléchissante dans le domaine du visible et de l'infra-rouge.

Un miroir comprend un substrat et une couche réfléchissante. Le substrat donne sa rigidité au miroir et sert de support au dépôt de la couche d'argent. Ce dépôt de la couche d'argent est le plus souvent réalisé par voie liquide à partir d'une solution d'argenture. On peut aussi réaliser la couche d'argent par pulvérisation d'argent à partir d'une source en argent, et notamment par le procédé dit de pulvérisation cathodique magnétron. Selon ce procédé, une cible en argent est placée vis-à-vis d'un substrat à recouvrir par le matériau de la cible dans une enceinte sous une atmosphère de dépôt comprenant un gaz rare. La cible fait office de cathode. Une tension de quelques centaines de volts est appliquée entre la cible et le bâti de l'installation. Le dépôt se fait sous un champ électrique et un champ magnétique. On ne donne pas plus de détails sur ce procédé bien connu de l'homme du métier.

On cherche à réaliser une couche d'argent la plus réfléchissante possible sur la gamme de longueurs d'onde du spectre solaire telle que définie par exemple dans la norme ISO9050, soit 295 à 2500 nm, surtout lorsque le miroir a vocation à collecter l'énergie solaire.

Le US2009/0233037 enseigne qu'une couche réfléchissante d'un miroir peut être réalisée par magnétron.

Le document EP1909120 enseigne la formation d'une couche d'argent sur miroir par pulvérisation cathodique.

Selon l'invention, on a découvert que la réflectivité de la couche d'argent pour la lumière arrivant côté verre et repartant côté verre était plus forte si le produit de la pression de l'atmosphère de dépôt comprenant un gaz rare par la distance cible/substrat était compris dans un domaine particulier. Ainsi, l'invention concerne en premier lieu un procédé de fabrication d'un miroir, tel que défini dans la revendication1, présentant une réflectivité définie selon la norme ISO9050 (masse d'air 1,5) supérieure à 70% entre 295 et 2500 nm, comprenant le dépôt d'une couche d'argent par pulvérisation cathodique magnétron à partir d'une cible en argent sur un substrat, le produit de la pression de l'atmosphère de dépôt comprenant un gaz rare par la distance entre la cible et le substrat étant compris entre 1,5 et 7 Pa.cm, et de préférence entre 2,5 et 6 Pa.cm.

La couche d'argent ainsi déposée a de préférence une réflectivité définie selon la norme ISO 9050 (masse d'air 1,5) supérieure à 80 %, voire supérieure à 85% entre 295 et 2500 nm.

Généralement, le dépôt est réalisé avec une densité de puissance surfacique comprise entre 0,2 et 1,1 Watt par cm² de substrat. De préférence, le début du dépôt est réalisé avec une densité de puissance surfacique comprise entre 0,2 et 0,7 Watts par cm² de substrat. Cette plus faible puissance concerne ainsi les premiers nanomètres de couche d'argent (3 à 50 nm). Ces premières conditions de dépôt peuvent être suivies de conditions de dépôt plus rapide jusqu'à la fin de la réalisation de la couche d'argent. Ainsi, la fin de la couche d'argent peut être réalisée avec une densité de puissance surfacique supérieure à la densité de puissance surfacique utilisée pour le début de la couche.

La couche d'argent présente une épaisseur totale comprise entre 60 et 200 nm, de préférence entre 100 et 200 nm. Ainsi la pulvérisation magnétron est réalisée pendant une durée nécessaire et suffisante pour déposer une épaisseur d'argent dans cette plage d'épaisseur.

La pression de l'atmosphère de dépôt est comprise entre 0,05 et 3 Pa. L'atmosphère de dépôt comprend un gaz rare. Généralement, le gaz de l'atmosphère de dépôt est l'argon ou le krypton. La pression partielle de gaz rare représente plus de 99% de la pression totale de l'atmosphère de dépôt. Généralement, l'atmosphère de dépôt est essentiellement du gaz rare, de sorte que l'on considère que la pression de l'atmosphère de dépôt est la pression de gaz rare.

Généralement, la tension de dépôt est comprise entre 100 et 600 volts.

Le substrat peut être en tout matériau conférant une rigidité suffisante au miroir. Généralement, le miroir est destiné à réfléchir la lumière au travers du substrat. Dans ce cas, le substrat est le plus transparent possible. Le substrat peut être en verre minéral (comprenant généralement plus de 40% en poids de silice) ou en verre organique comme en PMMA ou en polycarbonate. Pour le cas où le substrat est un verre minéral, celui-ci est de préférence extra-clair, c'est-à-dire présentant une transmission énergétique supérieure à 85% et même supérieure à 89% pour une épaisseur de verre de 3,2 mm (voir en particulier la norme ISO9050 (masse d'air 1,5). Cela ne signifie pas que le verre a nécessairement une épaisseur de 3,2 mm, cela signifie que la transmission énergétique est mesurée avec cette épaisseur. Le verre « diamant solaire » commercialisé par la société Saint-Gobain Glass France est particulièrement adapté. Un verre minéral utilisé comme substrat a généralement une épaisseur comprise entre 1,5 et 8 mm.

Avant le dépôt de la couche d'argent, il est préférable de déposer une mince couche d'accrochage directement sur le substrat. Il peut s'agir d'une couche comprenant du titane éventuellement au moins partiellement oxydée ou d'une couche d'un alliage Nickel-Chrome éventuellement au moins partiellement oxydée. Ces couches peuvent être déposées par pulvérisation cathodique magnétron. Cette couche d'accrochage peut donc être une couche magnétron de titane généralement partiellement oxydé que l'on note TiOₓ, x variant entre 0 et 2. Cette couche peut donc être aussi une couche magnétron d'un alliage Nickel-Chrome généralement partiellement oxydé que l'on note NiCrOₓ. Comme autre matériau convenant pour cette couche d'accrochage, on peut citer un alliage Etain-Zinc éventuellement au moins partiellement oxydé, éventuellement dopé par exemple avec l'aluminium. Comme autre matériau convenant pour cette couche d'accrochage, on peut citer le Zinc éventuellement au moins partiellement oxydé, éventuellement dopé par exemple avec l'aluminium. Un empilement d'au moins deux des matériaux venant d'être cités convient également comme couche d'accrochage.

L'épaisseur de cette couche d'accrochage peut par exemple aller de 0,1 nm (soit environ l'épaisseur d'une monocouche atomique) à 15 nm. Cette couche d'accrochage améliore l'adhésion de la couche d'argent et améliore la résistance du miroir au test CASS.

Si la couche d'accrochage est réalisée par pulvérisation cathodique magnétron, il est possible de réaliser la couche d'accrochage et la couche d'argent en continu l'une après l'autre dans une enceinte de dépôt magnétron administrant les couches l'une après l'autre sur les substrats en défilement.

Après réalisation de la couche d'argent, il est préférable de déposer sur elle une ou plusieurs couches de protection. Cette couche de protection peut avoir au moins l'une des fonctions suivantes:
- protection contre la corrosion de la couche d'argent,
- protection contre les UV pour le cas où une couche sensible aux UV est déposée après la couche d'argent, par exemple une couche de peinture comme par exemple enseigné par WO2010031981
- protection contre la dégradation de la couche d'argent pendant l'éventuel traitement thermique (bombage, trempe, recuit éventuellement par laser, flash heating) subséquent au dépôt de la couche d'argent.

Une ou plusieurs de ces couches peuvent être déposées après la couche d'argent par pulvérisation cathodique magnétron. Généralement cette couche de protection comprend au moins un des éléments du groupe Ti, Si, Sn, Zn, Mo, W, Hf, Cu, sous forme métallique ou (ce qui recouvre et/ou) oxydée ou (ce qui recouvre et/ou) nitrurée. Notamment, on peut déposer directement sur la couche d'argent une couche magnétron de nitrure de silicium selon les méthodes connues de l'homme du métier. Le nitrure de silicium sert à la fois de protection contre la corrosion et lors d'un éventuel traitement thermique. La cible du dispositif magnétron est alors généralement un alliage de silicium dopé à l'aluminium (typiquement autour de 3% d'aluminium). La couche procurant une protection de l'argent contre la corrosion ainsi qu'une protection de l'argent lors d'un éventuel traitement thermique peut également être une couche magnétron d'un oxyde métallique comme TiOₓ, MoOₓ, ZnOₓ, SiO₂, oxynitrure de silicium, Zn₂SnO₄, Al₂O₃.

Comme couche de protection contre les UV, on peut utiliser une couche magnétron d'oxyde de titane ou d'oxyde de zinc, ou une couche magnetron d'un métal comme le Cuivre, le Zinc ou d'un métal de transition comme Mo, Hf, W, Ti. Ces couches magnétron peuvent être déposées notamment selon les méthodes connues de l'homme du métier.

Si la couche de protection est réalisée par pulvérisation cathodique magnétron, il est possible de réaliser la couche d'argent et la couche de protection en continu l'une après l'autre dans une enceinte de dépôt magnétron administrant les couches l'une après l'autre sur les substrats en défilement. Une couche de protection magnétron (notamment en nitrure de silicium) peut avoir une épaisseur comprise entre 1 et 100 nm. On peut aussi déposer une couche de protection par magnétron suivie d'une couche de peinture de protection.

Un verre minéral faisant office de substrat dans le cadre de la présente invention peut être trempé thermiquement pour renforcer sa résistance mécanique. La trempe peut avoir été réalisée avant le dépôt de la couche d'argent. On peut aussi réaliser la trempe après le dépôt de la couche d'argent. Néanmoins le traitement de trempe implique un chauffage à haute température (suivi d'un refroidissement rapide) qui dégrade généralement fortement la couche d'argent si celle-ci n'est pas protégée. L'ajout sur la couche d'argent d'une couche de protection (notamment à base de nitrure de silicium) déposée par magnetron permet d'effectuer le traitement de trempe sans dégrader la couche d'argent. En outre, on a remarqué que ce traitement de trempe effectué après le dépôt de la couche magnetron d'argent augmente la réflectivité de la couche d'argent.

Généralement, le substrat et donc le miroir qui en dérive est plan. Alternativement, le miroir peut également être bombé. Le substrat peut être bombé avant le dépôt magnétron d'argent dès lors que le dispositif de dépôt magnétron est adapté aux formes bombées, par exemple possède un système de déplacement de la cible par rapport au substrat pour pouvoir respecter une distance optimale entre la cible et le substrat. Le miroir peut être bombé après dépôt de la couche d'argent. L'ajout d'une couche de protection (notamment à base de nitrure de silicium) déposée par magnétron permet d'effectuer le bombage à chaud sans dégrader la couche d'argent. En outre, on a remarqué que ce bombage à chaud effectué après le dépôt de la couche magnétron d'argent augmente la réflectivité de la couche d'argent.

On peut combiner le bombage et la trempe en réalisant ces deux traitements dans la foulée après dépôt de la couche d'argent. Ainsi, le traitement thermique servant au bombage sert aussi à atteindre la température nécessaire au traitement de trempe qui suit immédiatement le bombage. Ce traitement combiné (bombage à chaud suivi d'une trempe) effectué après le dépôt de la couche magnétron d'argent permet d'augmenter la réflectivité de la couche d'argent.

Généralement, dans le cadre d'une production en continu de miroirs, on fait défiler les substrats les uns après les autres dans un dispositif de dépôt par magnétron sous au moins une cible fixe dont au moins une est en argent. Ainsi, une multiplicité de substrats défile en continu sous une cible fixe en argent faisant office de cathode. Le substrat peut donc recevoir en continu pendant son défilement les différentes couches prévues comme d'abord la couche d'accrochage, puis la couche d'argent, puis la couche de protection. Toute cible du dispositif de dépôt magnétron (pour la couche d'accrochage, pour la couche d'argent, pour la couche de protection) est plus large que le substrat selon une vue correspondant à la direction de défilement des substrats. Ainsi, la cible peut déborder de chaque côté des substrats d'au moins 20 cm. La distance minimale entre la cible et le substrat est généralement comprise entre 5 et 20 cm. Transversalement par rapport à la direction de défilement des substrats, la cible peut avoir une largeur comprise entre 1 et 4 m. Les substrats défilent généralement à la vitesse de 0,05 à 15 m par minute.

Le miroir selon l'invention peut faire office de miroir solaire. Pour cette application, on préfère que le substrat soit en verre minéral. Si le miroir est plan et en application solaire, il est généralement un élément faisant partie d'un ensemble d'éléments miroirs disposés de sorte à constituer un miroir de Fresnel ou du type Heliostat. Cet ensemble fait converger la lumière solaire vers un collecteur de chaleur. Généralement, ce collecteur est constitué d'un tube parcouru par un fluide caloporteur (eau, sels fondus, huiles synthétiques, ou de la vapeur). Ce fluide est chauffé par l'énergie solaire et on lui fait restituer cette énergie sous forme d'électricité par tout procédé adapté comme par exemple celui dit de « Rankine Cycle ». Les problèmes liés aux fluctuations d'énergie inhérentes à l'énergie solaire (alternance du jour et de la nuit, passage de nuages) peuvent être contournés soit en stockant de la chaleur (avec un réservoir de fluide chaud) soit en hybridant les concentrateurs solaires avec une centrale thermique classique (la chaudière et la chaleur solaire alimentant la même turbine à vapeur). En fait, pour les applications en miroir de Fresnel ou Heliostat, les miroirs sont fabriqués plans mais sont légèrement bombés à la pose (bombage à froid) par application de contraintes mécaniques. On donne ainsi au vitrage une forme plus proche de la courbure idéale.

Dans le cas de miroirs du type héliostat, les différents éléments miroirs peuvent avoir une surface allant de 1 m² à 25 m².

Dans le cas d'un miroir de Fresnel, les différents éléments miroirs sont généralement de taille inférieure à 3 m². En effet, plus ces miroirs plans sont petits, plus on aura de facilité à les disposer pour faire converger les rayons lumineux vers le collecteur.

Généralement, la couche d'argent est cristallisée pour plus de 95% de sa masse, voire même plus de 98% de sa masse. Il semble que le procédé selon l'invention ait une influence bénéfique sur la cristallisation de l'argent dans la couche d'argent. Généralement, l'argent croît par le procédé selon l'invention selon un mode de croissance en colonne (les cristallites ont une forme de colonnes juxtaposées, l'axe des colonnes étant perpendiculaire au substrat). la description concerne également le miroir susceptible d'être fabriqué par le procédé selon l'invention. Ce miroir est notamment caractérisé par une réflectivité mesurée selon la norme ISO 9050 (masse d'air 1,5) d'au moins 70%, de préférence d'au moins 80%, voire 85% entre 295 et 2500 nm. L'invention concerne également l'utilisation d'un tel miroir pour collecter l'énergie solaire en déviant les rayons lumineux solaires vers un collecteur de chaleur.

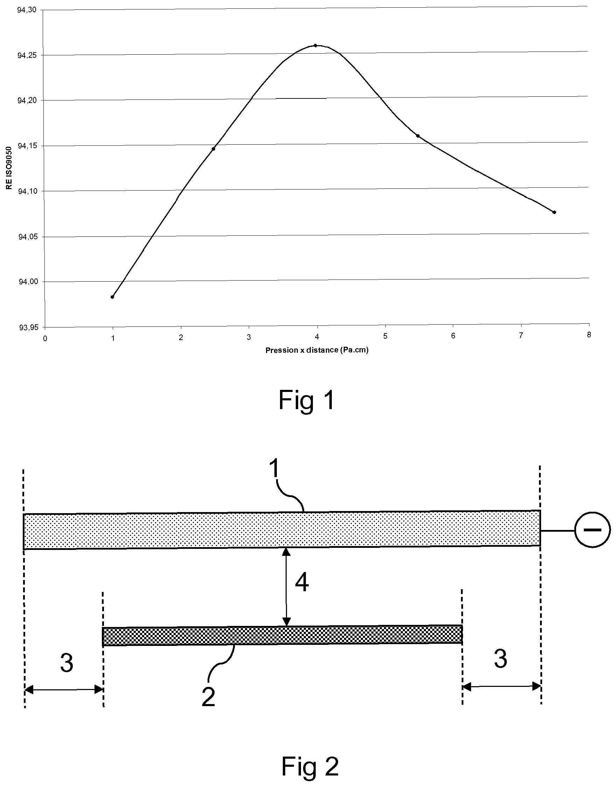

La figure 1 représente l'influence du produit de la pression de l'atmosphère de dépôt constituée essentiellement de gaz rare par la distance entre la cible et le substrat sur la réflectivité d'un miroir mesurée conformément à la norme ISO9050 (masse d'air 1,5).
La figure 2 représente un dispositif de déposition d'argent fonctionnant conformément au procédé magnétron selon l'invention. Une cible 1 fixe, en argent et faisant office de cathode, dépose de l'argent sur un substrat 2 en défilement dans une direction perpendiculaire au plan de la figure. Transversalement au sens de défilement du substrat, et selon une vue correspondant au sens de défilement des substrats, la cible 1 déborde en largeur du substrat 2 d'une distance 3 de chaque côté du substrat. La distance minimale 4 entre la cible et le substrat est comprise entre 5 et 20 cm.

### Exemples

On réalise des dépôts de couches d'argent par pulvérisation cathodique magnétron sur du verre « diamant » de 3 mm d'épaisseur commercialisé par la société Saint-Gobain Glass France, en faisant varier le produit de la pression partielle d'argon par la distance entre la cible et le substrat. L'atmosphère de dépôt est essentiellement de l'argon de sorte que la pression de l'atmosphère de dépôt correspond essentiellement à la pression partielle d'argon. Tous les dépôts réalisés avaient une épaisseur de 140 nm. La réflectivité était mesurée conformément à la norme ISO9050 (masse d'air 1,5). La figure 1 rassemble les résultats. On constate un maximum de réflectivité pour un produit de la pression partielle d'argon par la distance entre la cible et le substrat de 4 Pa.cm.

## Revendications

1. Procédé de fabrication d'un miroir, présentant une réflectivité supérieure à 70% entre 295 et 2500 nm, la réflectivité étant mesurée selon la norme ISO 9050 (masse d'air 1,5), comprenant le dépôt d'une couche d'argent par pulvérisation cathodique magnétron à partir d'une cible en argent sur un substrat dans une atmosphère de dépôt comprenant un gaz rare, **caractérisé en ce que** le produit de la pression de l'atmosphère de dépôt par la distance entre la cible et le substrat est compris entre 1,5 et 7 Pa.cm, la durée du dépôt de la couche d'argent étant telle que ladite couche a une épaisseur comprise entre 60 et 200 nm et la pression de l'atmosphère de dépôt étant comprise entre 0,05 et 3 Pa.

2. Procédé selon la revendication précédente, **caractérisé en ce que** le produit de la pression de l'atmosphère de dépôt par la distance entre la cible et le substrat est compris entre 2,5 et 6,0 Pa.cm.

3. Procédé selon l'une des revendications précédentes, **caractérisé en ce que** le dépôt est réalisé avec une densité de puissance surfacique comprise entre 0,2 et 1,1 Watt par cm² de substrat.

4. Procédé selon la revendication précédente, **caractérisé en ce que** le début du dépôt de la couche d'argent est réalisé avec une densité de puissance surfacique comprise entre 0,2 et 0,7 Watt par cm² de substrat.

5. Procédé selon l'une des revendications précédentes, **caractérisé en ce que** la pression partielle de gaz rare représente plus de 99% de la pression de l'atmosphère de dépôt.

6. Procédé selon l'une des revendications précédentes, **caractérisé en ce que** la distance minimale entre la cible et le substrat est comprise entre 5 et 20 cm.

7. Procédé selon l'une des revendications précédentes **caractérisé en ce qu'**une couche d'accrochage pouvant comprendre du titane éventuellement au moins partiellement oxydée ou pouvant comprendre un alliage Nickel-Chrome éventuellement au moins partiellement oxydée, est déposée par pulvérisation cathodique magnétron sur le substrat avant le dépôt de la couche d'argent.

8. Procédé selon l'une des revendications précédentes, **caractérisé en ce qu'**au moins une couche de protection notamment comprenant au moins un des éléments du groupe Ti, Si, Sn, Zn, Mo, W, Hf, Cu, sous forme métallique ou oxydée ou nitrurée est déposée par pulvérisation cathodique magnétron après le dépôt de la couche d'argent.

9. Procédé selon l'une des revendications précédentes, **caractérisé en ce qu'**une multiplicité de substrats défile en continu sous une cible fixe en argent faisant office de cathode.

10. Procédé selon l'une des revendications précédentes, **caractérisé en ce que** le substrat est en verre minéral.

11. Procédé selon l'une des revendications précédentes, **caractérisé en ce que** la durée du dépôt de la couche d'argent est telle que la couche d'argent a une épaisseur comprise entre 100 et 200 nm.

## Patentansprüche

1. Verfahren zur Herstellung eines Spiegels mit einem Reflexionsvermögen von mehr als 70 % zwischen 295 und 2500 nm, wobei das Reflexionsvermögen gemäß der ISO-Norm 9050 (Luftmasse 1,5) gemessen wird, umfassend die Abscheidung einer Silberschicht durch Magnetron-Sputtern von einem Silbertarget auf ein Substrat in einer Abscheidungsatmosphäre, die ein Edelgas umfasst, **dadurch gekennzeichnet, dass** das Produkt des Drucks der Abscheidungsatmosphäre durch den Abstand zwischen dem Target und dem Substrat zwischen 1,5 und 7 Pa.cm liegt, wobei die Dauer der Abscheidung der Silberschicht derart ist, dass die Schicht eine Dicke zwischen 60 und 200 nm aufweist und der Druck der Abscheidungsatmosphäre zwischen 0,05 und 3 Pa liegt.

2. Verfahren nach dem vorhergehenden Anspruch, **dadurch gekennzeichnet, dass** das Produkt des Drucks der Abscheidungsatmosphäre durch den Abstand zwischen dem Target und dem Substrat zwischen 2,5 und 6,0 Pa.cm liegt.

3. Verfahren nach einem der vorhergehenden Ansprüche, **dadurch gekennzeichnet, dass** die Abscheidung mit einer Oberflächenleistungsdichte zwischen 0,2 und 1,1 Watt pro cm² Substrat durchgeführt wird.

4. Verfahren nach dem vorhergehenden Anspruch, **dadurch gekennzeichnet, dass** der Beginn der Abscheidung der Silberschicht mit einer Oberflächenleistungsdichte zwischen 0,2 und 0,7 Watt pro cm² Substrat durchgeführt wird.

5. Verfahren nach einem der vorhergehenden Ansprüche, **dadurch gekennzeichnet, dass** der Partialdruck von Edelgas mehr als 99 % des Drucks der Abscheidungsatmosphäre ausmacht.

6. Verfahren nach einem der vorhergehenden Ansprüche, **dadurch gekennzeichnet, dass** der Mindestabstand zwischen dem Target und dem Substrat zwischen 5 und 20 cm liegt.

7. Verfahren nach einem der vorhergehenden Ansprüche, **dadurch gekennzeichnet, dass** eine Bindungsschicht, die gegebenenfalls mindestens teilweise oxidiertes Titan oder eine gegebenenfalls mindestens teilweise oxidierte Nickel-Chrom-Legierung umfassen kann, vor dem Abscheiden der Silberschicht durch Magnetron-Sputtern auf dem Substrat abgeschieden wird.

8. Verfahren nach einem der vorhergehenden Ansprüche, **dadurch gekennzeichnet, dass** mindestens eine Schutzschicht, insbesondere umfassend mindestens eines der Elemente aus der Gruppe Ti, Si, Sn, Zn, Mo, W, Hf, Cu, in metallischer oder oxidierter oder nitrierter Form, durch Magnetron-Sputtern nach der Abscheidung der Silberschicht abgeschieden wird.

9. Verfahren nach einem der vorhergehenden Ansprüche, **dadurch gekennzeichnet, dass** eine Vielzahl von Substraten kontinuierlich unter einem festen Silbertarget läuft, das als Kathode dient.

10. Verfahren nach einem der vorhergehenden Ansprüche, **dadurch gekennzeichnet, dass** das Substrat aus Mineralglas besteht.

11. Verfahren nach einem der vorhergehenden Ansprüche, **dadurch gekennzeichnet, dass** die Dauer der Abscheidung der Silberschicht derart ist, dass die Silberschicht eine Dicke zwischen 100 und 200 nm aufweist.

## Claims

1. A method of fabrication of a mirror, having a reflectivity greater than 70%, between 295 and 2500 nm, the reflectivity being measured according to the ISO 9050 standard (mass of air 1.5), comprising the deposition of a silver layer by magnetron sputtering from a silver target onto a substrate in a deposition atmosphere comprising a noble gas, **characterized in that** the product of the pressure of the deposition atmosphere times the distance between the target and the substrate is in the range between 1.5 and 7 Pa.cm, the duration of the deposition of the silver layer being such that the silver layer has a thickness in the range between 60 and 200 nm and the pressure of the deposition atmosphere being in the range between 0.05 and 3 Pa.

2. The method as claimed in the preceding claim, **characterized in that** the product of the pressure of the deposition atmosphere times the distance between the target and the substrate is in the range between 2.5 and 6.0 Pa.cm.

3. The method as claimed in one of the preceding claims, **characterized in that** the deposition is carried out with a surface power density in the range between 0.2 and 1.1 Watts per cm² of substrate.

4. The method as claimed in the preceding claim, **characterized in that** the start of the deposition of the silver layer is carried out with a surface power density in the range between 0.2 and 0.7 Watt per cm² of substrate.

5. The method as claimed in one of the preceding claims, **characterized in that** the partial pressure of noble gas represents over 99% of the pressure of the deposition atmosphere.

6. The method as claimed in one of the preceding claims, **characterized in that** the minimum distance between the target and the substrate is in the range between 5 and 20 cm.

7. The method as claimed in one of the preceding claims **characterized in that** an adhesion layer, which may comprise titanium which could be at least partially oxidized or which may comprise a nickel-chrome alloy which could be at least partially oxidized, is deposited by magnetron sputtering onto the substrate prior to the deposition of the silver layer.

8. The method as claimed in one of the preceding claims, **characterized in that** at least one protection layer notably comprising at least one of the elements from the group Ti, Si, Sn, Zn, Mo, W, Hf, Cu, in metallic or oxidized or nitrided form, is deposited by magnetron sputtering after the deposition of the silver layer.

9. The method as claimed in one of the preceding claims, **characterized in that** a multiplicity of substrates continuously passes under a fixed silver target acting as a cathode.

10. The method as claimed in one of the preceding claims, **characterized in that** the substrate is made of a mineral glass.

11. The method as claimed in one of the preceding claims, **characterized in that** the duration of the deposition of the silver layer is such that the silver layer has a thickness in the range between 100 and 200 nm.
